(19) Europäisches Patentamt
European Patent Office
Office européen des brevets

(11) **EP 2 193 360 B1**

(12) **FASCICULE DE BREVET EUROPEEN**

(45) Date de publication et mention
de la délivrance du brevet:
**05.11.2014 Bulletin 2014/45**

(51) Int Cl.:
***G01N 23/20*** (2006.01)     ***H01J 37/26*** (2006.01)
***H01J 37/295*** (2006.01)     ***H01L 21/66*** (2006.01)

(21) Numéro de dépôt: **08853292.4**

(22) Date de dépôt: **17.09.2008**

(86) Numéro de dépôt international:
**PCT/FR2008/001302**

(87) Numéro de publication internationale:
**WO 2009/068763 (04.06.2009 Gazette 2009/23)**

(54) **PROCEDE ET SYSTEME DE MESURE DE DEFORMATIONS A L'ECHELLE NANOMETRIQUE**

VERFAHREN UND SYSTEM ZUR MESSUNG NANOSKALIGER VERFORMUNGEN

METHOD AND SYSTEM FOR MEASURING NANOSCALE DEFORMATIONS

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **25.09.2007 FR 0706711**
**26.03.2008 FR 0801662**
**19.05.2008 FR 0802685**

(43) Date de publication de la demande:
**09.06.2010 Bulletin 2010/23**

(73) Titulaire: **Centre National de la Recherche Scientifique**
**75016 Paris (FR)**

(72) Inventeurs:
• **HYTCH, Martin**
**F-31000 Toulouse (FR)**
• **SNOECK, Etienne**
**F-31400 Toulouse (FR)**
• **HOUDELLIER, Florent**
**F-31560 Calmont (FR)**
• **HUE, Florian**
**F-75013 Paris (FR)**

(74) Mandataire: **Priori, Enrico et al**
**Cabinet Orès**
**36, rue de St. Pétersbourg**
**75008 Paris (FR)**

(56) Documents cités:
**EP-A- 1 508 801**     **JP-A- 2005 294 085**
**JP-A- 2008 021 626**     **US-A- 5 192 867**
**US-A- 5 828 724**     **US-A1- 2002 084 412**
**US-A1- 2003 201 393**     **US-A1- 2004 195 506**

• **AUVRAY P ET AL: "CARACTERISATION PAR DIFFRACTION X DES SUPERRESEAUX GAALAS-GAAS. IMPORTANCE DES TECHNIQUES ET DE LA PROCEDURE UTILISEES" REVUE DE PHYSIQUE APPLIQUEE, LES EDITIONS DE PHYSIQUE. PARIS, FR, vol. 24, no. 7, 1 juillet 1989 (1989-07-01), pages 711-720, XP000030268**
• **NIKULIN A YU ET AL: "Inversion in x-ray Bragg diffraction: A practical technique to compensate for dynamical scattering features" JOURNAL OF APPLIED PHYSICS, AMERICAN INSTITUTE OF PHYSICS. NEW YORK, US, vol. 82, no. 3, 1 août 1997 (1997-08-01), page 989, XP012043207 ISSN: 0021-8979**
• **JOHN M RODENBURG: "Understanding Transmission Electron Microscope Alignment: A Tutorial" MICROSCOPY AND ANALYSIS, JOHN WILEY & SONS LTD, UNITED KINGDOM, vol. 18, no. 3, 8 mai 2004 (2004-05-08), pages 9-11, XP002508736 ISSN: 0958-1952 cité dans la demande**
• **K-J HANSZEN ET AL: "Methods of off-axis electron holography and investigations of the phase structure in crystals" JOURNAL OF PHYSICS D. APPLIED PHYSICS, IOP PUBLISHING, BRISTOL, GB, vol. 19, no. 3, 14 mars 1986 (1986-03-14), pages 373-395, XP020013339 ISSN: 0022-3727**

**Description**

L'invention porte sur un procédé pour mesurer des déformations à l'échelle nanométrique dans un échantillon cristallin.

L'invention porte également sur un système pour la mise en oeuvre d'un tel procédé.

Le procédé et le système de l'invention visent à permettre de « cartographier » les contraintes dans un cristal, avec une résolution spatiale de l'ordre de quelques nanomètres. A cette échelle, les déformations induites par les contraintes se traduisent par des déformations du réseau cristallin de l'échantillon.

La mesure de déformations à l'échelle nanométrique trouve des applications technologiques diverses. Actuellement, l'application la plus importante concerne la cartographie des contraintes dans les transistors basées sur la technologie du silicium sous contrainte (« strained silicon »). Cette technologie, qui permet d'augmenter la fréquence de fonctionnement des dispositifs microélectroniques, est présentée dans le document « Intel's 90 nm Logic Technology Using Strained Silicon Transistors », M. Bohr, disponible sur l'Internet à l'adresse :

http://www.intel.com/research/downloads/Bohr-Strained-Silicon-120403.pdf.

Les techniques conventionnelles de mesure des déformations d'un échantillon, basées par exemple sur l'holographie optique, ne permettent pas d'atteindre des résolutions spatiales à l'échelle nanométrique. Les techniques connues de l'art antérieur et présentant une résolution suffisante sont basées sur la microscopie électronique en transmission, soit en mode diffractive, soit en mode d'imagerie. Ces techniques sont décrites de manière synthétique dans l'article de B. Foran et al. « Strain measurement by transmission electron microscopy », Future Fab International, 20 (2006) 127.

Parmi les techniques basées sur la diffraction des électrons on peut citer la CBED (diffraction d'électrons à faisceau convergent), la LACBED (CBED à grands angles) et la NBD (diffraction à faisceau nanométrique). Les deux premières techniques présentent l'inconvénient de ne fournir des informations sur la déformation de l'échantillon étudié que par comparaison entre les données de mesure et les résultats d'une simulation : les mesures sont donc indirectes et dépendent fortement des paramètres choisis pour la simulation. La dernière technique manque de précision. Par ailleurs, ces techniques rencontrent des difficultés quand le gradient des déformations est trop fort, par exemple dans le canal d'un transistor à silicium sous contrainte. En outre les mesures sont ponctuelles, ou tout au plus effectuées sur une ligne, et doivent donc être répétées plusieurs fois pour permettre de cartographier en deux dimensions les déformations d'un échantillon.

La technique d'imagerie basée sur le contraste de diffraction (QEDC) souffre d'inconvénients similaires.

D'autres techniques d'imagerie, telles que la microscopie électronique en transmission à haute résolution (HRTEM) présentent au contraire l'avantage d'être « directes », et de ne dépendre pas d'un choix particulier de paramètres de simulations. Cependant, ces techniques ne fournissent qu'une image du réseau cristallin à l'échelle nanométrique ; la détermination d'un état de déformation suppose qu'un réseau de référence soit disponible. Or, pour imager un réseau cristallin, il est nécessaire de l'agrandir très fortement (d'un facteur d'environ $5 \cdot 10^5$), ce qui implique que le champ de vue est nécessairement étroit (de l'ordre de 100 - 150 nm). Il n'est donc pas possible, en général, de visualiser en même temps une région déformée et une région sans déformation qui puisse servir de référence.

Par ailleurs, toutes ces techniques (et plus particulièrement la HRTEM) ne fonctionnent de manière satisfaisante qu'avec des échantillons très minces, d'une épaisseur de quelques dizaines de nanomètres au plus pour la HRTEM. Or, lorsqu'on extrait une lame aussi fine d'une structure massive, les contraintes se relaxent de manière significative. Les déformations mesurées dans l'échantillon ne sont donc plus représentatives de celles présentes dans la structure d'origine. Ce problème est bien connu dans la technique : voir par exemple l'article de M. M. J. Treacy et al. « On elastic relaxation and long wavelength microstructures in spinoidally decomposed InxGa1-xAsyP1-y epitaxial layers » Philos. Mag. A 51 (1985) 389.

L'invention vise à rendre disponible une technique de mesure des déformations cristallines d'un échantillon, avec une résolution spatiale à l'échelle nanométrique, ne présentant pas au moins certains des inconvénients de l'art antérieur.

Un objet de l'invention est donc un procédé de mesure de déformations à l'échelle nanométrique dans une portion d'un échantillon cristallin selon la revendication 1, ledit procédé étant caractérisé en ce qu'il comporte les étapes consistant à :

i. préparer un échantillon cristallin en forme de lame à faces sensiblement parallèles, ledit échantillon comprenant une première zone, dite de mesure, dont on veut mesurer les déformations cristallines, et une seconde zone, dite de référence, supposée sans déformations et coplanaire avec la première zone ;
ii. éclairer une face dudit échantillon par un faisceau spatialement cohérent d'un rayonnement susceptible d'être diffracté par le réseau cristallin de l'échantillon ;

iii. superposer un faisceau du rayonnement diffracté par la zone de mesure de l'échantillon avec un faisceau du même rayonnement diffracté, au même ordre, par la zone de référence, de manière à faire interférer ces deux faisceaux diffractés au niveau d'un plan dit plan image ;

iv. mesurer la périodicité spatiale et l'orientation des franges de la figure d'interférence qui en résulte ; et

v. en déduire une différence de paramètre cristallin et/ou d'orientation entre lesdites zones de référence et de mesure, indicative d'un état de déformation à l'échelle nanométrique de cette dernière.

Des modes de réalisation particuliers du procédé de l'invention font l'objet des revendications dépendantes 2 à 9.

Un autre objet de l'invention est un système de mesure de déformations à l'échelle nanométrique dans une portion d'un échantillon cristallin par un tel procédé. Un tel système, qui fait l'objet de la revendication 10, est caractérisé en ce qu'il comporte : un support pour un échantillon cristallin en forme de lame à faces sensiblement parallèles ; des moyens d'éclairage pour éclairer une face dudit échantillon par un faisceau spatialement cohérent d'un rayonnement susceptible d'être diffracté par le réseau cristallin de l'échantillon ; un montage optique pour superposer un faisceau du rayonnement diffracté par une première zone de l'échantillon avec un faisceau du même rayonnement diffracté, au même ordre, par une seconde zone, coplanaire avec ladite première zone, de manière à faire interférer ces deux faisceaux diffractés au niveau d'un plan dit plan image ; un moyen pour mesurer la périodicité spatiale des franges de la figure d'interférence qui en résulte ; et un moyen de traitement des données pour calculer, à partir de ladite périodicité spatiale, une différence de paramètre cristallin entre lesdites première et seconde zone de l'échantillon, indicative d'un état de déformation à l'échelle nanométrique de l'une de ces zones par rapport à l'autre.

Un tel système peut être réalisé à partir d'un microscope électronique de type conventionnel. Cependant, cette solution n'est pas pleinement satisfaisante, en particulier lorsqu'on souhaite mesurer les déformations dans une région relativement grande d'un échantillon (plusieurs $\mu m^2$).

D'autres caractéristiques, détails et avantages de l'invention ressortiront à la lecture de la description faite en référence aux dessins annexés donnés à titre d'exemple et qui représentent, respectivement :

- la figure 1, un schéma de principe d'un procédé de mesure de déformations cristallines par observation de « franges de moiré » ;
- la figure 2, un schéma de principe du procédé de l'invention ;
- la figure 3, un schéma de principe d'un système de microscopie électronique en transmission pour la mise en oeuvre du procédé de l'invention ;
- La figure 4a, un schéma simplifié d'un système de microscopie électronique en transmission pour la mise en oeuvre du procédé de l'invention, comprenant un dispositif d'optique électronique selon un premier mode de réalisation de l'invention ;
- La figure 4b, un schéma simplifié d'un système de microscopie électronique en transmission pour la mise en oeuvre du procédé de l'invention, comprenant un dispositif d'optique électronique selon un deuxième mode de réalisation de l'invention ;
- La figure 5, un ensemble pouvant être introduit dans la colonne d'un microscope électronique préexistant et portant les éléments essentiels du dispositif d'optique électronique selon l'invention ; et
- La figure 6, le résultat d'une mesure de déformation cristalline dans un transistor réalisée conformément à l'invention.

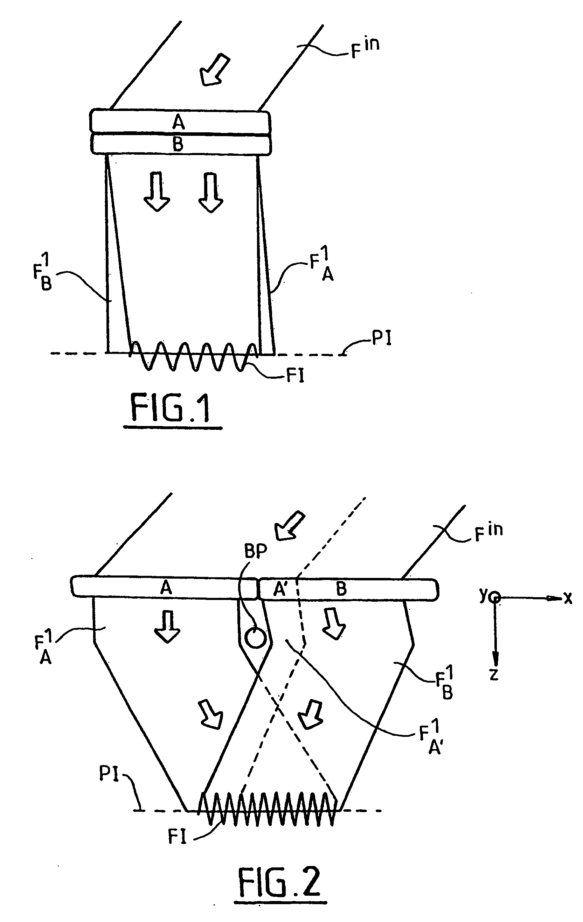

La figure 1 montre un schéma de principe d'une technique, connue en particulier de l'ouvrage de P. B. Hirsch et al « Electron Microscopy of Thin Crystals, 2nd Edition », Krieger, Malabar Florida, 1977, chapitre 15, permettant de mettre en évidence des différences entre les réseaux cristallins de deux matériaux.

Pour mettre en oeuvre cette technique on doit réaliser un empilement de deux échantillons (A et B) des matériaux dont on veut comparer les réseaux cristallins. Cet empilement est éclairé par un faisceau spatialement cohérent d'électrons, $F^{in}$, qui le traverse et dont une portion est diffractée par les deux réseaux cristallins. On indique par $F^1_A$ le faisceau diffracté au premier ordre par l'échantillon A, et par $F^1_B$ le faisceau diffracté, également au premier ordre, par l'échantillon B ; on néglige la portion du rayonnement qui est diffractée par les deux échantillons à la fois, et on ne s'intéresse ni à la transmission à l'ordre zéro, ni aux ordres supérieurs de diffraction.

Si les réseaux cristallins des échantillons A et B ne sont pas identiques, les faisceaux $F^1_A$ et $F^1_B$ se propagent selon des directions différentes, et interfèrent entre eux. En mesurant la périodicité spatiale de la figure d'interférence FI dans un plan image PI, on peut obtenir une information sur la différence entre les vecteurs de diffusion dans A et dans B. On en déduit la différence entre les paramètres cristallins des deux échantillons (ou plutôt, une composante de cette différence, qui est une grandeur vectorielle).

En principe, cette technique pourrait être appliquée à la cartographie des déformations dans un matériau. Il faudrait à cet effet superposer deux échantillons du même matériau, l'un présentant un champ de déformations à caractériser et l'autre, supposé non déformé, utilisé en tant que référence. Cependant, en pratique, une telle application se heurterait à des difficultés quasiment insurmontables. En effet, il n'est pas simple de préparer un empilement d'échantillons ayant la configuration nécessaire. En outre, pour pouvoir interpréter correctement les résultats il faudrait connaître très précisément l'orientation relative des réseaux cristallins des deux échantillons.

Par ailleurs, si les déformations du réseau cristallin sont relativement faibles (de l'ordre de quelques pourcent), les franges d'interférences seront très espacées entre elles, par conséquent la résolution spatiale de la mesure sera médiocre. Par exemple, dans le cas des plans (111) du silicium, une déformation de 1% produirait des franges de 30 nm de largeur, ce qui donnerait une résolution spatiale d'environ 60 nm.

Le procédé de l'invention se base également sur l'observation de franges d'interférence entre faisceaux d'électrons diffractés par un réseau cristallin déformé et par un réseau de référence, mais utilise une configuration expérimentale plus facile à mettre en oeuvre et permettant d'atteindre une meilleurs résolution spatiale.

L'idée à la base de l'invention, représentée sur la figure 2, consiste à disposer les deux zones cristallines, celle dont on veut cartographier les contraintes (A) et celle qui sert de référence (B), côte à côte. Les faisceaux diffractés par les deux zones, $F^1_A$ et $F^1_B$, sont ensuite faits converger sur un écran de détection disposé dans un plan image PI à l'aide d'un dispositif de déflexion BP, par exemple un biprisme électrostatique.

La nouvelle configuration est avantageuse, car elle permet de s'affranchir des problèmes liés au désalignement des réseaux cristallins des deux zones à comparer. Par ailleurs, les échantillons sont plus faciles à préparer : il suffit par exemple d'extraire une « tranche » d'un substrat semiconducteur à la surface duquel est réalisé un dispositif électronique de type transistor, le plan de coupe étant perpendiculaire à ladite surface. Dans ce cas, le dispositif électronique de surface constitue la zone à mesurer, et la partie plus profonde du substrat forme la zone de référence. On sait couper de telles tranches, avec le niveau de précision souhaité et une épaisseur de l'ordre de 100 nm ou plus, avec la technique des faisceaux ioniques focalisés. Voir par exemple l'article de T. Ishitani, K. Umemura, T. Ohnishi, T. Yaguchi et T. Kamino « Improvements in performance of focused ion beam cross-sectioning: aspects of ion-sample interaction », Journal of Electron Microscopy 53 (2004) 443-449.

La technique de l'invention peut s'appliquer à des échantillons en forme de lame à face planes parallèles ayant une épaisseur relativement importante, de manière indicative comprise entre 50 et 600 nm et de préférence entre 100 et 300 nm (à comparer avec les 10 nm de la technique HRTEM), ce qui atténue le problème de la relaxation des contraintes. Cela est dû au fait que seul un ordre de diffraction du faisceau de rayonnement est sélectionné, ce qui limite l'augmentation du bruit de fond due à toute la diffusion dudit rayonnement par l'échantillon. Le contraste est amélioré par rapport à la technique HRTEM à cause de la séparation plus importante des franges, qui sont donc plus faciles à imager.

En revanche, il faut que l'échantillon présente une épaisseur constante avec une bonne précision (meilleure de 15%, de préférence meilleure de 5%), mais cela peut être obtenu de manière relativement simple par la technique précitée des faisceaux ioniques focalisés.

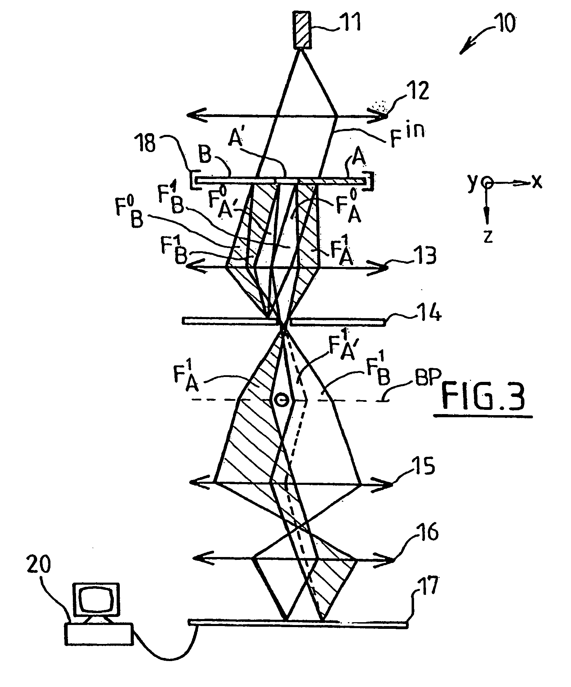

L'utilisation d'un dispositif de déflexion de type biprisme pour faire converger les faisceaux $F^1_A$ et $F^1_B$ présente également l'avantage d'augmenter l'angle entre lesdits faisceaux. Il en résulte des franges d'interférence avec une période spatiale moindre par rapport à la technique de moiré « classique » (figure 1), et par conséquent une meilleure résolution spatiale de la mesure. A titre d'exemple, les faisceaux $F^1_A$ et $F^1_B$ peuvent former entre eux un angle, rapporté au plan de l'échantillon (plan objet), compris entre 1et 20 mrad (milliradians). L'angle « rapporté au plan de l'échantillon » est l'angle réel formé par les faisceaux lorsqu'ils interfèrent au niveau du détecteur (plan image), multiplié par le grandissement du système de projection généralement disposé en amont de ce dernier (lentilles 15, 16 sur la figure 3).

On donne maintenant une description mathématique du principe de la technique de l'invention (les symboles en caractères gras représentent des grandeurs vectorielles).

Soit $\mathbf{k_0}$ le vecteur d'onde du faisceau électronique incident sur l'échantillon, $F_{IN}$, et $g_A$, $g_B$ les vecteurs du réseau réciproque correspondant aux plans cristallins responsables de la diffraction dans les zones A et B, respectivement. On sait de la théorie de la diffraction que les vecteurs d'onde des faisceaux $F^1_A$ et $F^1_B$, indiqués par $\mathbf{k_A}$ et $\mathbf{k_B}$, sont données par : $\mathbf{k_A} = \mathbf{k_0} + \mathbf{g_A}$ et $\mathbf{k_B} = \mathbf{k_0} + \mathbf{g_B}$ ; les angles de diffractions associés au vecteurs $g_A$, $g_B$ sont généralement de l'ordre de 2 - 40 mrad, et typiquement compris entre 8 et 20 mrad. L'action du biprisme BP sur ces faisceaux peut être représentée par un vecteur d'onde additionnel $q_c$ ; en supposant une action de déflexion symétrique on peut écrire, après le biprisme, $\mathbf{k_A} = \mathbf{k_0} + \mathbf{g_A} + 1/2\ \mathbf{q_c}$ et $\mathbf{k_B} = \mathbf{k_0} + \mathbf{g_B} - 1/2\ \mathbf{q_c}$. Dans le plan image PI, la superposition des deux faisceaux produit une figure d'interférence dont la périodicité (définie comme-étant égale au réciproque de la période) est donnée par $\mathbf{k_H} = \mathbf{k_B} - \mathbf{k_A} = \mathbf{g_B} - \mathbf{g_A} - \mathbf{q_c}$. Si on connaît la valeur de $\mathbf{q_c}$, on peut en déduire $\mathbf{g_B} - \mathbf{g_A}$, qui caractérise la déformation du réseau cristallin de la zone « de mesure » B par rapport à celui de la zone de référence A. Ce vecteur, en soi, est peu informatif : par exemple, il ne permet pas de distinguer une modification du paramètre cristallin (due à une compression ou à une dilatation) d'une rotation du réseau. Pour pouvoir exploiter le résultat de la mesure, il est généralement nécessaire de connaître, en plus, la direction et le module du vecteur $g_A$ (vecteur réciproque du réseau de la zone de référence). Cela se fait sans difficulté particulière en observant la figure de diffraction produite par la zone de référence à l'infini (concrètement, dans le plan du diaphragme 14 du dispositif représenté sur la figure 3), ce qui donne la direction. Le module peut être calculé à partir des paramètres connus du cristal A et rapporté au plan image en prenant en compte le grandissement.

La mesure de la périodicité et de l'orientation des franges d'interférence ne pose pas de difficultés particulières : il suffit d'acquérir une image de la figure d'interférence à l'aide d'un capteur adapté, tel qu'une matrice CCD, la convertir en format numérique, puis effectuer un traitement mathématique de l'image. Un tel traitement peut être basé, par exemple, sur la méthode d'analyse des phases géométriques (GPA), connu de l'article de M. J. Hÿtch et al. « Quantitative measurement of displacement and strain fields from HREM micrographs », Ultramicroscopy 74 (1998) 131, voir en particulier les paragraphes 2.2 et 3. Bien que d'autres méthodes d'analyse puissent également être utilisées, la méthode GPA est particulièrement avantageuse. Pour cette raison son utilisation sera décrite de manière détaillée.

Premièrement, on calcule la transformée de Fourier de la figure d'interférence. Puis, on sélectionne uniquement la partie de cette transformée de Fourier correspondant à la périodicité des franges holographiques, égal (approximativement) à $q_c$, à l'aide d'un masque présentant une largeur de l'ordre de cette périodicité. La transformée de Fourier inverse de cette zone sélectionnée donne un signal bidimensionnel complexe, dont la phase est dite « image de phase géométrique brute » (« raw-phase image ») et contient toute l'information relative à la déformation de la zone B de l'échantillon qui peut être obtenue par le procédé de l'invention. Notamment, le dérivé de la phase donne la périodicité et l'orientation locales des franges.

Pour corriger les distorsions du système optique utilisée pour la mise en oeuvre du procédé, il est possible d'effectuer une mesure de référence avec un cristal « parfait », ou des hologrammes de référence, dont la phase géométrique brute devrait être une fonction linéaire. Tout écart par rapport à l'allure linéaire attendue est dû aux distorsions du système optique, et peut donc être soustraite à l'image de phase brute de l'échantillon à étudier, suivant la procédure décrite par Hüe et al. « Calibration of projector lens distortions » J. Electron Microscopy 54 (2005) 181-190.

Le module et la direction du vecteur d'onde de déflexion $\mathbf{q_c}$ constituent des paramètres de calibrage importants ; il est donc préférable de les mesurer, plutôt que de les estimer sur la base de simulations.

Une première possibilité pour mesurer ces paramètres de calibrage est de faire interférer les faisceaux transmis à l'ordre zéro, éventuellement en l'absence de l'échantillon. On comprend facilement que la mesure de la périodicité des franges donne directement le module de $q_c$, tandis que leur orientation donne sa direction.

Une autre possibilité, représentée sur les figures 2 et 3, consiste à positionner le biprisme BP de manière excentrée par rapport à la frontière entre les zones de référence et de mesure ; par exemple, dans le cas des figures, le fil réalisant le biprisme est disposé au-dessous de la zone de référence. On indique par A' la partie de la zone de référence qui se trouve « au-delà » du biprisme, du côté de la zone B. Dans ces conditions, le rayonnement $F^1_{A'}$ diffracté par la région A' interfère avec le rayonnement $F^1_A$ diffracté par le restant de la zone de référence, A. Comme $g_{A'} = g_A$, une partie de la figure d'interférence présentera des franges de périodicité spatiale égale à $q_c$. Si la méthode GPA est appliquée au procédé à l'invention, le vecteur $q_c$ sera donné par le gradient de la partie de l'image de phase brute correspondant à la zone A'.

Une seule mesure ne permet pas de caractériser complètement le tenseur de déformation dans l'échantillon étudié. En effet, en se référant au système d'axes cartésiens représenté à côté de la figure 2, une mesure effectuée conformément à ladite figure ne fournit que des informations sur la distance interatomique le long de l'axe $g_A$ (qui est ici supposé coïncider sensiblement avec l'axe X).

Un champ de déformation en deux dimensions peut être déterminé en effectuant deux mesures successives. Il est nécessaire que les vecteurs de diffraction $g''_A$, $g''_B$ des faisceaux diffractés sélectionnés pour la deuxième mesure ne soient pas colinéaires aux vecteurs de diffraction correspondants, $\mathbf{g'_A}$, $\mathbf{g'_B}$ de la première mesure. Par dérivation des images de phase correspondantes, on peut facilement calculer le tenseur de déformation du réseau cristallin de la zone de mesure par rapport à celui de la zone de référence : voir l'article précité de M. J. Hÿtch et al., paragraphe 4.

Une troisième mesure, effectuée en sélectionnant des faisceaux diffractés selon des vecteurs de diffraction $\mathbf{g'''_A}$, $\mathbf{g'''_B}$ non coplanaires avec les vecteurs correspondants de la première et de la deuxième mesure, peut permettre de déterminer un champ de déformation en trois dimensions. Un facteur de correction doit être appliqué au champ de déplacement déterminé lors de la troisième mesure, pour prendre en compte le fait que le vecteur $g'''_A$ (respectivement, $g'''_B$) est incliné par rapport au plan $g'_A$, $g''_A$ ($g'_B$, $g''_B$).

La figure 3 montre une vue simplifiée d'un système pour la mise en oeuvre du procédé de l'invention.

Le système comporte un canon à électrons 11 pour la génération d'un faisceau spatialement cohérent d'électrons, $F^{in}$. Après avoir été collimaté par un condenseur électromagnétique 12, le faisceau est dirigé vers un échantillon A/A'/B, maintenu par un porte échantillon 18. L'angle d'incidence du faisceau $F^{in}$ sur l'échantillon est choisi de manière à permettre la diffraction dudit faisceau par des plans atomiques du cristal.

En aval de l'échantillon, un diaphragme 14, situé dans le plan focal d'un objectif 13, sélectionne uniquement le rayonnement diffracté au premier ordre, $F_A^1$, $F_{A'}^1$, $F_B^1$ et supprime, en particulier, le rayonnement transmis à l'ordre zéro $F_A^0$, $F_{A'}^0$, $F_B^0$. Les faisceaux diffractés sont ensuite déviés par un biprisme BP, constitué par un fil conducteur chargé à un potentiel prédéterminé, typiquement compris entre 40 et 400 V, mais dépendant entre autres de l'énergie du faisceau d'électrons. La figure montre un dispositif utilisant un biprisme simple ; l'utilisation de biprismes multiples peut s'avérer avantageuse afin de pouvoir régler de manière indépendante le champ de vue et la résolution spatiale de la mesure.

Ensuite, un système de lentilles de projection 15, 16 superpose les faisceaux $F_A^1$ et $F_A'^1$- $F_B^1$ dans un plan image FI, où est disposé un détecteur matriciel 17 relié à un moyen d'élaboration des données 20 qui calcule la périodicité des franges d'interférence et en déduit une composante de la différence de paramètre cristallin entre les zones A et B de l'échantillon.

Le système de la figure 3 est basé sur un microscope électronique en transmission. En effet, pour des raisons technologiques, l'utilisation de faisceaux d'électrons est généralement préférée. La nature physique du rayonnement utilisé n'a pas une importance fondamentale, pourvu que ce rayonnement présente la cohérence spatiale requise et ait une longueur d'onde du même ordre de grandeur du paramètre cristallin de l'échantillon. Bien entendu, il faut également qu'un dispositif de déflexion des faisceaux soit disponible. On peut donc envisager des modes de réalisation de l'invention exploitant la diffraction de rayons X, de neutrons, d'ions et même d'atomes neutres.

Un système pour la mise en oeuvre du procédé de l'invention peut être basé sur un microscope électronique du commerce. Or, un tel microscope comporte généralement un objectif principal dont la longueur focale est de l'ordre de 1 mm et qui introduit un grandissement important (de l'ordre de 50), ne permettant pas à la réalisation de mesures à faible ou moyenne résolution et à grand champ de vue.

Par conséquent, pour la mise en oeuvre de la méthode de l'invention avec un champ de vue suffisamment large, c'est à dire de plusieurs $\mu m^2$ (ci-après « mode large champ ») il est nécessaire de ne pas alimenter l'objectif principal et d'utiliser comme objectif une autre lentille de la colonne, située plus en aval par rapport au sens de propagation du faisceau électronique.

Cette solution n'est pas satisfaisante. En effet :

- L'agencement de la colonne du microscope ne permet généralement pas d'introduire un diaphragme dans le plan focal de la lentille utilisée comme objectif. Or, un diaphragme est nécessaire pour sélectionner les faisceaux électroniques diffractés au premier ordre : on est donc obligés d'utiliser dans ce but le diaphragme de l'objectif principal. Mais les faisceaux électroniques ne sont pas focalisés dans le plan de ce diaphragme : ces faisceaux seront donc coupés de manière asymétrique à des angles qui dépendent de la zone de l'échantillon dont ils sont issus. Cela introduit une distorsion de l'image hors-axe. En outre, pour ne pas couper excessivement les faisceaux diffractés, il est nécessaire d'avoir recours à un diaphragme relativement large, qui n'élimine pas efficacement les électrons diffusés. Il en résulte une réduction du contraste de l'image.
- En mode large champ, le système optique du microscope ne permet pas la formation d'une vraie image focalisée du diaphragme objectif principal. Son placement est donc difficile.
- Le faisceau électronique diffracté par l'échantillon doit être centré sur l'axe optique du microscope, et se propager parallèlement à ce dernier. Cela signifie que le faisceau incident doit être suffisamment incliné. Or, les systèmes d'éclairage conventionnels en mode large champ limitent fortement l'angle d'inclinaison maximale du faisceau électronique incident, ce qui oblige à utiliser un faisceau très énergétique, pour lequel l'angle de diffraction est relativement petit. Même avec cette précaution, certains échantillons restent hors de portée de la méthode.

L'utilisation d'un microscope en mode double lentille (ou « dual-lens », voir le document US 7,015,469) permet d'atténuer ce dernier problème, mais laisse subsister les autres.

Le dispositif d'optique électronique qui constitue l'un des objets de l'invention permet de résoudre ces problèmes. En outre, ce dispositif peut également trouver application dans d'autres techniques d'holographie électronique, en champ clair.

Comme expliqué plus haut, un tel dispositif comprend : un couple de bobines déflectrices de faisceau ; des moyens d'insertion pour placer un échantillon sur le trajet d'un faisceau électronique ayant traversé ledit couple de bobines déflectrices ; une première lentille électromagnétique pour former une image dudit échantillon ; et un diaphragme disposé dans le plan focal image de ladite première lentille et centré sur l'axe optique de cette dernière, pour intercepter des électrons focalisés par ladite première lentille hors dudit axe optique ; et se caractérise en ce que lesdits moyens d'insertion sont adaptés pour permettre le positionnement d'un échantillon à l'extérieur d'une région à fort champ magnétique de ladite première lentille électromagnétique, en amont de cette dernière par rapport à la direction de propagation dudit faisceau électronique.

Les différents éléments du dispositif sont connus par eux-mêmes, et se retrouvent dans un microscope électronique conventionnel, mais pas selon l'agencement de l'invention. En effet, dans un microscope électronique conventionnel l'échantillon est situé à l'intérieur de l'objectif, immergé dans son champ magnétique, et pas en amont de ce dernier. La seule exception est constituée par les microscopes utilisant comme objectif une lentille « dite » de Lorentz, qui se caractérise par un champ magnétique quasi-nul au niveau du plan de l'échantillon ; voir par exemple, K Tsuno and T Taoka, Japanese Journal of Applied Physics 22 (1983) 1041. Mais ces microscopes utilisés dans le cadre de mesures particulières, en particulier sur des échantillons magnétiques, ne comportent pas de diaphragme dans le plan focal de l'objectif, et la structure dudit objectif ne permet pas, concrètement, l'introduction d'un tel diaphragme.

Une précision s'impose au sujet de la notion de plan focal d'une lentille électromagnétique. En principe, la longueur focale d'une telle lentille n'est pas fixe, mais varie en fonction du courant électrique d'alimentation. En réalité, cependant, les aberrations sphérique et chromatique sont minimisées par une valeur déterminée de longueur focale, et augmentent rapidement en s'éloignant de cette valeur. Par conséquent, une lentille électromagnétique ne peut être utilisée en pratique qu'à l'intérieur d'une plage relativement restreinte de longueurs focales. Autrement dit, le plan focal d'une lentille électromagnétique peut se déplacer seulement à l'intérieur d'une région spatiale limitée. D'ailleurs, la gamme des distances focales utilisables doit rester compatible avec les caractéristiques des lentilles qui suivent dans la colonne, et qui sont à des positions fixes.

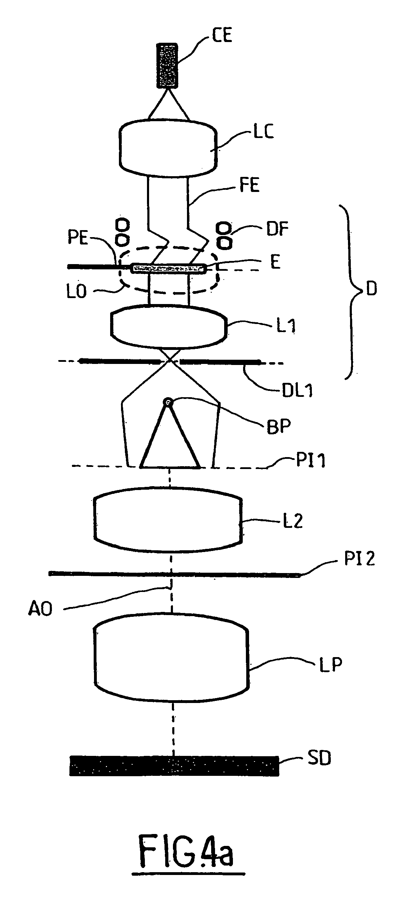

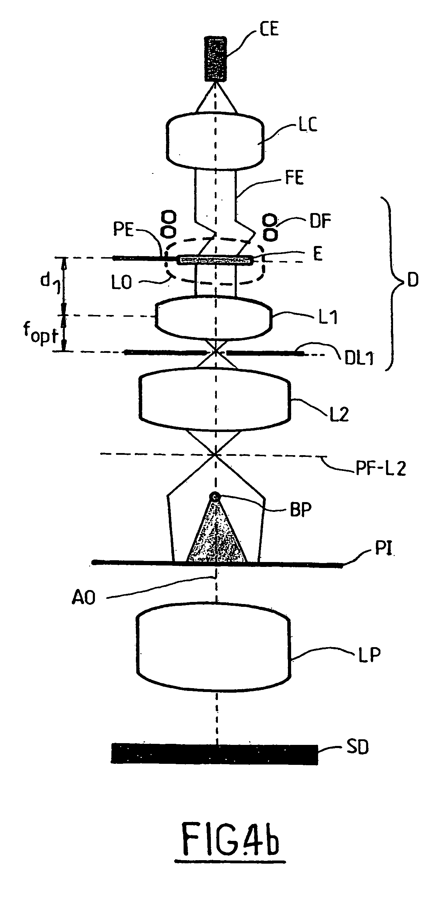

Les figures 4a et 4b montrent comment le procédé de l'invention peut être mis en oeuvre à l'aide d'un microscope électronique à transmission commercial modifié en introduisant dans sa colonne électronique un dispositif selon l'invention.

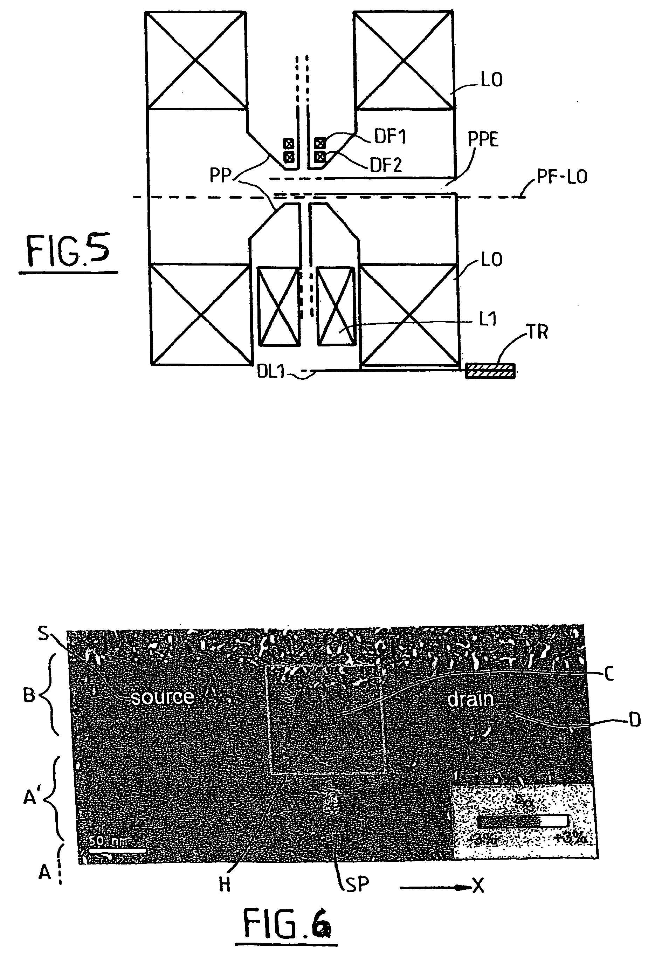

Comme dans le cas de la figure 3, un faisceau électronique collimaté FE est généré par un canon électronique CE couplé à un condensateur CE. Mais, à la sortie du condensateur, ce faisceau se propage parallèlement à l'axe optique AO du microscope. Un couple de bobines déflectrices DF (DF1, DF2 sur la figure 5) dévie ce faisceau, tout en le décalant latéralement pour qu'il soit incident sur l'échantillon E en position centrée par rapport audit axe optique. D'une manière conventionnelle, le point en correspondance duquel le faisceau dévié croise l'axe optique est appelé « point pivot ». Le courant d'alimentation des bobines déflectrices doit donc être choisi de telle manière que leur point pivot soit positionné sur la surface de l'échantillon.

La notion de point pivot et le fonctionnement des bobines déflectrices sont expliqués en détail dans l'article de John M. Rodenburg « Understanding Transmission Electron Microscope Alignment : A Tutorial », Microscopy and Analysis 18 (3), 9 - 11, 2004.

Il est intéressant de noter que les bobines déflectrices peuvent être désactivées, pour passer à un mode d'imagerie « classique » en champ claire, sans que le faisceau électronique se déplace latéralement quittant la région d'intérêt.

L'agencement respectif des bobines déflectrices et du porte-échantillon PE est choisi de manière à permettre une inclinaison suffisante (au moins 5 mrad et de préférence entre 5 et 35 mrad) du faisceau FE en mode grand champ, notamment en les positionnant le plus près possible de l'objet.

Dans les figures, seul un couple de déflectrices est représenté. En pratique, cependant, on utilisera de préférence deux couples, permettant de dévier le faisceau dans deux plans perpendiculaires.

Comme expliqué plus haut, l'angle d'inclinaison du faisceau incident est choisi de telle manière que le faisceau diffracté au premier ordre par l'échantillon soit parallèle à l'axe optique. L'angle d'inclinaison, $\theta_g$, est donc donné dans l'approximation des petits angles par :

$$\theta_g = \lambda/d_g$$

où $\lambda$ est la longueur d'onde des électrons incidents, et $d_g$ est la distance entre les plans atomiques qui diffractent. Pour une tension d'accélération de $V_o$ Volts, la longueur d'onde $\lambda$ est donné par :

$$\lambda(nm) = 1{,}22639/(V_o + 0{,}97845 \times 10^{-6} V_o^2)^{0,5}.$$

La séparation des plans (hkl) dans un matériau cubique est donnée par:

$$d_g = a/\sqrt{(h^2 + k^2 + l^2)}$$

où a est le paramètre de maille.

Pour des applications à la microélectronique, il faut pouvoir observer le silicium. Les plans les plus espacés, et donc qui donnent les angles les plus faibles, sont de type {111}. Si on veut pouvoir mesurer les déformations cristallines dans la direction de type <110> avec un seul hologramme, il faut pouvoir utiliser les plans de type {220}. Pour la direction <100>, il faut utiliser les plans de type {400}.

Le tableau ci-après donne les angles requis pour les différents plans cristallins du silicium à trois valeurs d'énergie des électrons.

| Silicium | a = 0,543 nm | 80 kV | 200 kV | 300 kV |
|---|---|---|---|---|
| | | 4,18 pm | 2,51 pm | 1,97 pm |

(suite)

| Silicium | a = 0,543 nm | 80 kV | 200 kV | 300 kV |
|---|---|---|---|---|
| | λ<br>$d_g$ | | | |
| {111} | 0,313 nm | 13,3 mrad (0,77°) | 8 mrad (0,46°) | 6,3 mrad (0,36°) |
| {220} | 0,192 nm | 21,8 mrad (1,25°) | 13,1 mrad (0,75°) | 10,3 mrad (0,59°) |
| {004} | 0,136 nm | 30,7 mrad (1,8°) | 18,4 mrad (1°) | 14,5 mrad (0,83°) |

L'énergie du faisceau d'électrons incident sur l'échantillon est généralement comprise entre 20 keV et 3 MeV, et de préférence entre 80 keV et 300 keV. En particulier dans le cas du silicium, il est préférable d'utiliser des électrons d'énergie inférieure à 140 keV pour éviter d'induire un endommagement de type dit « knock-on », qui peut provoquer à son tour une relaxation des contraintes que l'on cherche à mesurer.

Pour le germanium, les angles indiqués dans le tableau doivent être augmentés de 4,1%.

Les figures 4a et 4b représentent également, en trait pointillé, l'emplacement de la lentille objectif LO du microscope dans sa configuration conventionnelle.

Lors de la mise au point de l'instrument, il est nécessaire de régler finement l'orientation de l'échantillon E. Pour cette raison, il est opportun qu'il soit porté par le porte-échantillon PE au niveau du plan eucentrique de ce dernier. Les bobines déflectrices DF1, DF2 sont conçues de manière à diriger le faisceau électronique en position centrée sur l'échantillon E lorsque ce dernier se trouve dans le plan eucentrique de l'échantillon, et cela indépendamment de l'angle d'inclinaison du faisceau incident. Autrement dit, le point pivot du couple de déflectrice doit peut être amené dans le plan eucentrique du porte-échantillon PE.

Une lentille électromagnétique L1 est disposée en aval de l'échantillon E, dans le sens de propagation du faisceau électronique, à une distance $d_1 > 0$ de ce dernier. Cette lentille doit fournir un grandissement relativement faible, typiquement compris entre 3 et 20, et de préférence entre 5 et 10, pour permettre d'obtenir un champ de vue suffisamment large. Pour cela, elle doit avoir une longueur focale optimale $f_{opt}$, c'est à dire minimisant les aberrations, relativement longue, c'est à dire supérieure ou égale à 5 mm, de préférence comprise entre 5 et 30 mm, et d'une manière encore préférée comprise entre 10 et 20 mm. Pour comparaison, l'objectif principal d'un microscope électronique conventionnel présente typiquement une longueur focale de l'ordre de 1 mm.

Pour rappel, si f est la longueur focale de la lentille L1, le grandissement de l'échantillon E est donné par $f/(d_1-f)$. Cela signifie que la distance $d_1$ est du même ordre de grandeur que la longueur focale f de la lentille. L'échantillon est donc spatialement séparé de la lentille L1, alors que dans un microscope électronique conventionnel, il se trouve immergé dans le champ magnétique de l'objectif principal.

La résolution spatiale ponctuelle ρ de l'instrument dépend à la fois de la longueur d'onde des électrons et de la constante d'aberration sphérique $C_s$, $\rho = 0{,}67\, C_s^{0,25}\lambda^{0,75}$.

Le tableau suivant donne la valeur de $C_s$ (dimensionnellement homogène à une longueur) en fonction de la résolution requise et de la tension d'accélération des électrons :

| | tension d'accélération | | |
|---|---|---|---|
| résolution | 80 kV | 200 kV | 300 kV |
| 0,5 nm | 4 mm | 20 mm | 40 mm |
| 1 nm | 6,8 cm | 31 cm | 65 cm |
| 2 nm | 1,1 m | 5,0 m | 10 m |
| 4 nm | 17 m | 80 m | 160 m |

Pour une résolution spatiale ponctuelle de 1 nm à 200 kV, il faut donc une $C_s$ d'un maximum de 31 cm. La constante d'aberration sphérique est typiquement de l'ordre de la longueur focale de la lentille. Une $C_s$ de 10 cm à 1 m pour des lentilles d'une longueur focale de l'ordre de 20 mm est possible. Voir à ce propos :

- M.A. Schofield, M. Beleggia, Y. Zhu and G. Pozzi, « Characterization of JEOL 2100F Lorentz-TEM for low-magnification electron holography and magnetic imaging », Ultramicroscopy (2007) -doi:10:1016/j.ultramic.2007.10.015.
- E. Snoeck, P. Hartel, H. Mueller, M. Haider & P.C. Tiemeijer, « Using a CEOS-objective lens corrector as a pseudo Lorentz lens in a Tecnai F20 TEM », Proc. IMC16 Sapporo (2006) CD.

L'ultime limite de la résolution est la limite d'information de la lentille. Cette limite est typiquement plus grande que la limite de résolution ponctuelle. Elle est déterminée par les incohérences et les instabilités du système. Le facteur le plus important est l'aberration chromatique de la lentille conjuguée avec la largeur énergétique de la source d'électrons.

La lentille L1 peut être une lentille de Lorentz.

Un diaphragme DL1 est positionné, de manière réglable et mobile, dans le plan focal image de la lentille L1 pour couper le faisceau électronique transmis par l'échantillon à l'ordre zéro, les électrons diffusés et les ordres supérieurs de diffraction. Typiquement, il est requis de couper les faisceaux à des angles (rapportés au plan de l'échantillon) de l'ordre de 1 mrad de l'axe optique AO. Dans le plan focal image, les faisceaux à un angle de θ apparaissent à une distance de l'axe optique de f fois θ, où f est la longueur focale de la lentille L1. Comme la longueur focale de la lentille L1 est plus grande que celle d'un objectif classique, l'ouverture du diaphragme DL1 sera, elle aussi, plus grande de celle d'un diaphragme classique. Le centrage de ce diaphragme sera donc plus simple.

En aval du diaphragme DL1, et en amont du plan de l'image de l'échantillon formée par la lentille L1 (plan P11) se trouve un biprisme BP de type classique, simple ou multiple.

La figure 4a montre une deuxième lentille électromagnétique L2, située en aval du biprisme BP et du plan image P11. Cette lentille peut avoir une double fonction :

- premièrement, elle permet de former une image du plan focal de L1, afin de pouvoir placer le diaphragme ;

deuxièmement, elle permet de former l'image du plan image PI1 dans un deuxième plan image PI2, afin de réaliser un hologramme.

En aval de cette deuxième lentille se trouvent des lentilles de projection LP conventionnelles, qui projettent l'hologramme réalisé dans le plan PI2 sur le détecteur matriciel SD.

Selon la variante de la figure 4b, la deuxième lentille L2 (qui peut être un ensemble de lentilles) peut être placée en amont du biprisme. Cette configuration est avantageuse, car elle permet de faire tourner l'image de l'échantillon par rapport au biprisme, de manière à obtenir un effet équivalent à une rotation physique de l'échantillon lui-même ou du biprisme, ce qui est nécessaire pour aligner le biprisme parallèlement à l'interface entre les zones A et B). Pour des raisons mécaniques, il est préférable de faire tourner l'image de l'échantillon plutôt que le biprisme ou l'échantillon lui-même: en effet, il existe une orientation particulière de stabilité maximale du biprisme ou de l'échantillon par rapport à la colonne du microscope. Cependant, le grandissement introduit par cette deuxième lentille avant le biprisme est susceptible de limiter le champ de vue.

La figure 5 montre un ensemble « monolithique » qui peut être introduit dans un microscope électronique commercial en remplacement de son objectif principal afin de l'adapter à la mise en oeuvre de la technique holographique de mesure des déformations cristallines décrite ci-dessus. Cet ensemble est essentiellement constitué par le couple de bobines déflectrices, DF1 et DF2, l'objectif LO pourvu d'un passage PPE dans lequel peut être introduit un porte-échantillon de type classique et d'un diaphragme DLO dans son plan focal (la longueur focale de l'objectif est tellement courte que le plan focal se trouve à l'intérieur de la lentille elle-même), la lentille L1 et le diaphragme associé DL1, monté sur un translateur TR. En raison de ses grandes dimensions, l'objectif LO constitue avantageusement l'élément structurel commun auquel sont reliés tous les autres composants de l'ensemble. En particulier, les déflectrices sont situées immédiatement en amont des pièces polaires dudit objectif, tandis que la première lentille L1 est située à l'intérieur des enroulements de l'objectif, en aval de la région à fort champ magnétique (entre les pièces polaires).

Un diaphragme (non représenté) peut également être prévu dans le plan focal PF-LO de l'objectif LO. De façon connue en soi, ce plan focal gît à l'intérieur de l'objectif LO lui-même.

En variante, on pourrait prévoir un ensemble ne comprenant pas l'objectif LO, et ne permettant donc pas un fonctionnement en imagerie « conventionnelle ». Dans ce cas, les composants DF, L1 et DL1 seraient reliés par un élément structurel, qui peut être notamment constitué par la lentille L1 elle-même.

En tout cas, l'ensemble de la figure 5 peut comporter également d'autres éléments tels que la deuxième lentille L2 ou le biprisme BP, si ces composants ne sont pas prévus dans le microscope électronique commercial.

Le dispositif des figures 4a, 4b et 5 a été décrit en référence au procédé de mesure des déformations microscopique selon l'invention. Cependant, il pourrait s'appliquer également à d'autres techniques holographiques « en champ clair », nécessitant d'un champ de vue relativement large. En particulier, le diaphragme DL1 permet d'éliminer les électrons diffusés à des angles supérieurs à celui correspondant à la résolution spatiale de la lentille, améliorant ainsi le rapport signal-sur-bruit des franges holographiques.

La figure 6 montre un exemple de cartographie des déformations - et plus précisément de la composante $\varepsilon_{xx}$ du tenseur de déformation - obtenu par le procédé de l'invention. L'échantillon est constitué par une tranche d'un transistor à effet de champ de type MOSFET, réalisé selon la technologie du silicium sous contrainte. On peut observer que le canal C du transistor, compris entre la source S et le collecteur (drain) D, est en compression d'environ 1,3% par rapport à la partie « profonde » $P du substrat, qui sert de référence. Le carré désigné par H montre le champ visuel de la technique HRTEM. On peut voir que cette technique ne permet pas d'imager en même temps la zone sous contrainte et une zone de référence : elle ne permet donc pas de quantifier la déformation cristalline, sauf par comparaison de plusieurs images distinctes, ce qui est susceptible d'introduire des erreurs de mesure inacceptables.

Dans une mesure effectuée conformément à l'invention, le champ de vue est typiquement de l'ordre de 2 $\mu$m parallèlement à l'interface entre les zones A' et B, et d'environ 250 nm perpendiculairement à ladite interface. Mais des champs de vue plus larges, par exemple jusqu'à 4 $\mu$m X 2 $\mu$m, peuvent être obtenus. La résolution spatiale est de l'ordre de quelques nanomètres, typiquement 2 à 4. Les champs de déplacement et les tenseurs de déformation peuvent être mesurés avec une précision qui dépend de la résolution spatiale ; par exemple, avec une résolution de 4 nm on peut atteindre une précision de l'ordre de 0,2%, et avec une résolution de 2 nm une précision de 0,4% environ.

La technique peut être utilisée pour cartographier les déformations dans des échantillons de nature différentes : des dispositifs microélectroniques, comme dans le cas de la figure 6, mais également des tranches d'un système de couches minces ou revêtements déposés sur un substrat, une zone endommagée ou perturbée d'un échantillon cristallin, une région d'interface entre deux cristaux, etc. Par ailleurs, les zones de référence et de mesure ne doivent pas nécessairement être en contact direct entre elles : on peut également imaginer de poser deux cristaux l'un à côté de l'autre sur un porte-échantillon adapté, tel qu'une pellicule de carbone.

## Revendications

1. Procédé de mesure de déformations à l'échelle nanométrique dans une portion (B) d'un échantillon cristallin, **caractérisé en ce qu'**il comporte les étapes consistant à :

   i. préparer un échantillon cristallin en forme de lame à faces sensiblement parallèles, ledit échantillon comprenant une première zone (B), dite de mesure, dont on veut mesurer les déformations cristallines, et une seconde zone (A), dite de référence, supposée sans déformations et coplanaire avec la première zone ;
   ii. éclairer une face dudit échantillon par un faisceau ($F^{in}$) spatialement cohérent d'un rayonnement susceptible d'être diffracté par le réseau cristallin de l'échantillon ;
   iii. superposer un faisceau ($F^1_B$) du rayonnement diffracté par la zone de mesure (B) de l'échantillon avec un faisceau ($F^1_A$) du même rayonnement diffracté, au même ordre, par la zone de référence (A), de manière à faire interférer ces deux faisceaux diffractés au niveau d'un plan dit plan image (PI) ;
   iv. mesurer la périodicité spatiale et l'orientation des franges de la figure d'interférence (FI) qui en résulte ; et
   v. en déduire une différence de paramètre cristallin et/ou d'orientation entre lesdites zones de référence et de mesure, indicative d'un état de déformation à l'échelle nanométrique de cette dernière.

2. Procédé selon la revendication 1, dans lequel ladite étape consistant à superposer deux faisceaux dudit rayonnement diffractés par lesdites zones de référence et de mesure comporte l'utilisation d'un dispositif de déflexion (BP) des faisceaux de type biprisme, ledit procédé comportant également

   vi. une étape de calibrage, pour mesurer la modification de direction du ou des faisceaux diffractés ($F^1_A$, $F^1_B$) introduite par ledit dispositif de déflexion (BP) ; et

   - l'utilisation de l'information ainsi obtenue lors de l'étape v. de détermination d'une différence de paramètre cristallin entre lesdites zones de référence et de mesure.

3. Procédé selon la revendication 2 où, lors de ladite étape de calibrage :

   vi-a. on superpose, pour les faire interférer au niveau dudit plan image, deux parties spatialement distinctes ($F^1_A$, $F^1_{A'}$) d'un même faisceau diffracté par l'une seule (A, A') desdites zones de l'échantillon ; et
   vi-b. on mesure la périodicité spatiale et l'orientation des franges de la figure d'interférence qui en résulte, et qui constitue l'information de calibrage recherchée.

4. Procédé selon la revendication 2 où, lors de ladite étape de calibrage :

   vi-a'. on génère un faisceau de rayonnement cohérent ($F^{in}$) sensiblement identique à celui utilisé pour la mesure de déformation cristalline ;
   vi-b'. à l'aide dudit dispositif de déflexion (PB), on décompose une composante non diffractée dudit faisceau en deux parties qui se superposent et interfèrent au niveau dudit plan image ;
   vi-c'. on mesure la périodicité spatiale et l'orientation des franges de la figure d'interférence qui en résulte, et qui constitue l'information de calibrage recherchée.

**5.** Procédé selon l'une des revendications 2 à 4, dans lequel l'étape v. de détermination d'une différence de paramètre cristallin entre lesdites zones de référence et de mesure comporte :

- le calcul, à partir de la mesure de la périodicité spatiale et l'orientation des franges d'interférence, d'une différence entre des composantes des vecteurs d'onde des faisceaux diffractés par la zone de mesure et par la zone de référence ;
- la détermination, lors de ladite étape vi. de calibrage, d'une composante d'un vecteur d'onde représentatif de la déflexion introduite par ledit dispositif (BP) ; et
- la soustraction de ladite composante du vecteur d'onde représentatif de la déflexion introduite par ledit dispositif, de ladite différence entre des composantes des vecteurs d'onde des faisceaux diffractés ;

ce qui fournit comme résultat une différence entre des composantes des vecteurs des réseaux cristallins réciproques desdites zones de référence et de mesure, indicative d'une déformation à l'échelle nanométrique de cette dernière.

**6.** Procédé selon l'une des revendications précédentes, dans lequel ladite ou chaque étape de mesure de la périodicité spatiale de franges d'interférence comporte :

iv-a. l'acquisition d'une image de la figure d'interférence (FI) au niveau dudit plan image ;
iv-b. la conversion de ladite image en format numérique ; et
iv-c. la détermination de la périodicité desdites franges par une méthode de traitement d'images par analyse des phases géométriques.

**7.** Procédé selon l'une des revendications précédentes, dans lequel les étapes ii. à v. sont répétées une deuxième fois en utilisant des faisceaux ($F^1_A$, $F^1_B$) diffractés selon des vecteurs de diffraction non colinéaires aux vecteurs de diffraction de la première mesure, et de préférence également une troisième fois en utilisant des faisceaux ($F^1_A$, $F^1_B$) diffractés selon des vecteurs de diffraction non coplanaires aux vecteurs de diffraction de la première et de la deuxième mesure, pour déterminer un tenseur de déformation en deux ou en trois dimensions respectivement de la zone de mesure (B) dudit échantillon.

**8.** Procédé selon l'une des revendications précédentes, dans lequel l'échantillon est sensiblement transparent au rayonnement incident ($F^{in}$), et une diffraction vers l'avant dudit rayonnement est exploité pour la mesure.

**9.** Procédé selon l'une des revendications précédentes, dans lequel le rayonnement utilisé ($F^{in}$) est constitué par un faisceau d'électrons.

**10.** Système de mesure de déformations à l'échelle nanométrique dans une portion d'un échantillon cristallin par un procédé selon l'une des revendications précédentes, **caractérisé en ce que** ledit système comporte :

- un support (18) pour un échantillon cristallin en forme de lame à faces sensiblement parallèles ;
- des moyens d'éclairage (11 ; 12) pour éclairer une face dudit échantillon par un faisceau spatialement cohérent d'un rayonnement ($F^{in}$) susceptible d'être diffracté par le réseau cristallin de l'échantillon (A, B) ;
- un montage optique (13, 14, BP, 15, 16) pour superposer un faisceau du rayonnement ($F^1_B$) diffracté par une première zone de l'échantillon avec un faisceau du même rayonnement diffracté, au même ordre, par une seconde zone (F'A1), coplanaire avec ladite première zone, de manière à faire interférer ces deux faisceaux diffractés au niveau d'un plan dit plan image (PI) ;
- un moyen (17) pour mesurer la périodicité spatiale des franges de la figure d'interférence qui en résulte ; et
- un moyen (20) de traitement des données pour calculer, à partir de ladite périodicité spatiale, une différence de paramètre cristallin entre lesdites première et seconde zone de l'échantillon, indicative d'un état de déformation à l'échelle nanométrique de l'une de ces zones par rapport à l'autre.

**Patentansprüche**

**1.** Verfahren zur Messung von Verformungen auf Nanometer-Skala in einem Abschnitt (B) einer kristallinen Probe, **dadurch gekennzeichnet, dass** es Schritte umfasst, bestehend aus:

i. Präparieren einer kristallinen Probe in Form eines Blattes mit im Wesentlichen parallelen Seiten, wobei die Probe eine erste Zone (B), genannt Messzone, an welcher beabsichtigt ist, Kristallverformungen zu messen, und eine zweite Zone (A), genannt Referenzzone, aufweist, welche als ohne Verformungen angenommen wird und koplanar zu der ersten Zone ist;

ii. Bestrahlen einer Seite der Probe mit einem räumlich kohärenten Strahl ($F^{in}$) einer Strahlung, welche dazu geeignet ist, von dem Kristallgitter der Probe gebrochen zu werden;

iii. Überlagern eines Strahls ($F^1_B$) der von der Messzone (B) der Probe gebrochenen Strahlung mit einem Strahl ($F^1_A$) derselben Strahlung, welche in gleicher Ordnung von der Referenzzone (A) gebrochen wurde, auf solche Weise, dass diese zwei gebrochenen Strahlen auf einer Ebene, genannt Bildebene (PI), zur Interferenz gebracht werden;

iv. Messen der räumlichen Periodizität und der Orientierung von Streifen des daraus resultierenden Interferenzmusters; und

v. Darausherleiten einer Differenz eines Kristallparameters oder einer Ausrichtung zwischen der Referenz- und Messzone, welche einen Verformungszustand auf Nanometerskala der letzteren anzeigt.

2. Verfahren nach Anspruch 1, wobei der Schritt, welcher darin besteht, zwei durch die Referenz- und Messzone gebrochene Strahlen der Strahlung zu überlagern, eine Nutzung einer Vorrichtung zur Ablenkung (BP) der Strahlen vom Doppelbrechungstyp umfasst, wobei das Verfahren außerdem umfasst:

vi. einen Schritt einer Kalibrierung, zur Messung der Änderung einer Richtung des oder der gebrochenen Strahlen ($F^1_A$, $F^1_B$), welche durch die Vorrichtung zur Ablenkung (BP) eingeführt wird; und

- Nutzung der so erhaltenen Information bei dem Schritt v. einer Bestimmung einer Differenz eines Kristallparameters zwischen der Referenz- und Messzone.

3. Verfahren nach Anspruch 2, wobei bei dem Schritt einer Kalibrierung:

vi-a. zwei räumlich getrennte Teile ($F^1_A$, $F^1_{A'}$) eines selben von einer einzigen (A, A') der Zonen der Probe gebrochenen Strahls überlagert werden, um sie auf Höhe der Bildebene zur Interferenz zu bringen; und

vi-b. die räumliche Periodizität und die Orientierung der Streifen des Interferenzmusters, welches daraus resultiert, gemessen werden, was die gesuchte Kalibrierungsinformation darstellt.

4. Verfahren nach Anspruch 2, wobei bei dem Schritt einer Kalibrierung:

vi-a'. ein Strahl einer kohärenten Strahlung ($F^{in}$) erzeugt wird, welcher im Wesentlichen identisch zu demjenigen ist, welcher für die Messung der Kristallverformung genutzt wird;

vi-b'. mit Hilfe der Vorrichtung zur Ablenkung (PB) ein nicht gebrochener Bestandteil des Strahls in zwei Teile zerlegt wird, welche sich überlagern und auf Höhe der Bildebene interferieren;

vi-c'. die räumliche Periodizität und die Orientierung der Streifen des Interferenzmusters gemessen wird, welches daraus resultiert, gemessen werden, was die gesuchte Kalibrierungsinformation darstellt.

5. Verfahren nach einem der Ansprüche 2 bis 4, wobei der Schritt v. einer Bestimmung einer Differenz eines Kristallparameters zwischen der Referenz- und Messzone umfasst:

- Berechnung, ausgehend von der Messung der räumlichen Periodizität und Orientierung der Interferenzstreifen, einer Differenz zwischen Komponenten von Wellenvektoren der von der Messzone und von der Referenzzone gebrochenen Strahlen;

- Bestimmung, bei dem Schritt vi. einer Kalibrierung, einer Komponente eines Wellenvektors, welcher die durch die Vorrichtung (BP) eingeführte Ablenkung darstellt; und

- Subtraktion der Komponente, das die von der Vorrichtung eingeführte Ablenkung darstellenden Wellenvektors von der Differenz zwischen den Komponenten der Wellenvektoren der gebrochenen Strahlen;

was als Resultat eine Differenz zwischen den Komponenten von reziproken Kristallgittervektoren der Referenz- und Messzone liefert, welche eine Verformung auf Nanometerskala der letzteren anzeigt.

6. Verfahren nach einem der vorhergehenden Ansprüche, wobei der oder jeder Schritt einer Messung der räumlichen Periodizität von Interferenzstreifen umfasst:

iv-a. Aufnehmen eines Bildes des Interferenzmusters (FI) auf Höhe der Bildebene;

iv-b. Umwandlung des Bildes in ein digitales Format; und

iv-c. Bestimmung der Periodizität der Streifen über ein Bildverarbeitungsverfahren durch Analyse von geometrischen Phasen.

7. Verfahren nach einem der vorhergehenden Ansprüche, wobei die Schritte ii. - v. ein zweites Mal wiederholt werden, wobei gebrochene Strahlen ($F^1_A$, $F^1_B$) verwendet werden, welche gemäß Brechungsvektoren gebrochen wurden, welche nicht kolinear zu den Brechungsvektoren der ersten Messung sind, und vorzugsweise ein drittes Mal wiederholt werden, wobei gebrochene Strahlen ($F^1_A$, $F^1_B$) verwendet werden, welche gemäß Brechungsvektoren gebrochen wurden, welche nicht koplanar zu den Brechungsvektoren der ersten und der zweiten Messung sind, um einen Verformungstensor der Messzone (B) der Probe in zwei beziehungsweise drei Dimensionen zu bestimmen.

8. Verfahren nach einem der vorhergehenden Ansprüche, wobei die Probe im Wesentlichen transparent für eintreffende Strahlung ($F^{in}$) ist, und eine vorwärtsgerichtete Brechung der Strahlung für die Messung genutzt wird.

9. Verfahren nach einem der vorhergehenden Ansprüche, wobei die verwendete Strahlung ($F^{in}$) durch einen Elektronenstrahl gebildet ist.

10. System zur Messung von Verformungen auf Nanometer-Skala in einem Abschnitt in einer kristallinen Probe durch ein Verfahren nach einem der vorhergehenden Ansprüche, **dadurch gekennzeichnet, dass** das System umfasst:

- eine Halterung (18) für eine kristalline Probe in Form eines Blattes mit im Wesentlichen parallelen Seiten;
- Mittel zur Bestrahlung (11; 12), um eine Seite der Probe durch einen räumlich kohärenten Strahl einer Strahlung ($F^{in}$) zu bestrahlen, welche geeignet ist, durch das Kristallgitter der Probe (A, B) gebrochen zu werden;
- eine optische Einrichtung (13, 14, BP, 15, 16), um einen von einer ersten Zone der Probe gebrochenen Strahl der Strahlung ($F^1_B$) mit einem Strahl derselben Strahlung zu überlagern, welcher in derselben Ordnung von einer zweiten Zone ($F^1_A$), koplanar mit der ersten Zone, gebrochen wurde, derart zu überlagern, dass diese zwei gebrochenen Strahlen auf Höhe einer als Bildebene (PI) bezeichneten Ebene zur Interferenz gebracht zu werden;
- ein Mittel (17) zur Messung der räumlichen Periodizität der Streifen des Interferenzmusters, welches daraus resultiert; und
- ein Mittel (20) zur Verarbeitung von Daten, um ausgehend von der räumlichen Periodizität eine Differenz eines Kristallparameters zwischen der ersten und zweiten Zone der Probe zu berechnen, welche einen Verformungszustand auf Nanometer-Skala der einen dieser Zonen im Verhältnis zu der anderen anzeigt.

**Claims**

1. A method for measuring nanoscale deformations in a portion (B) of a crystal specimen, **characterized in that** it comprises steps consisting in:

i) preparing a crystal specimen in the form of a wafer with approximately parallel faces, said specimen comprising a first area (B), called the measurement area, of which the crystal deformations are to be measured, and a second area (A), called the reference area, assumed to be without deformations and coplanar with the first area;
ii) illuminating one face of said specimen with a spatially coherent beam ($F^{in}$) of radiation capable of being diffracted by the crystal lattice of the specimen;
iii) superposing a beam ($F^1_B$) of radiation diffracted by the measurement area (B) of the specimen with a beam ($F^1_A$) of the same radiation diffracted, to the same order, by the reference area (A) so as to cause these two diffracted beams to interfere at a plane called the image plane (PI);
iv) measuring the spatial periodicity and the orientation of the fringes of the resulting interference pattern (FI); and
v) deducing from this a difference in the lattice parameter and/or the orientation between said reference and measurement areas, which is indicative of a state of deformation of the latter at the nanoscale.

2. The method as claimed in claim 1, in which said step consisting in superposing two beams of said radiation diffracted by said reference and measurement areas comprises the use of a biprism beam deflection device (BP), said method also comprising :

vi) a calibration step in order to measure the change in direction of the diffracted beam(s) ($F^1_A$, $F^1_B$) introduced by said deflection device (BP); and

- use of the information thus obtained during step v) of determining a difference in the lattice parameter between said reference and measurement areas.

**3.** The method as claimed in claim 2, where, during said calibration step:

vi-a) two spatially distinct parts ($F^1_A$, $F^1_{A'}$) of the same beam diffracted by only one (A, A') of said areas of the specimen are superposed to cause them to interfere at said image plane; and
vi-b) measurement is carried out of the spatial periodicity and the orientation of the fringes of the resultant interference pattern, which constitute the calibration information sought.

**4.** The method as claimed in claim 2, where, during said calibration step:

vi-a') a coherent radiation beam ($F^{in}$) is generated which is approximately identical to that used for the crystal deformation measurement;
vi-b') using said deflection device (PB) a nondiffracted component of said beam is decomposed into two parts that are superposed and interfere at said image plane;
vi-c') measurement is carried out of the spatial periodicity and the orientation of the fringes of the resultant interference pattern, which constitute the calibration information sought.

**5.** The method as claimed in one of claims 2 to 4, in which step v) of determining a difference in the lattice parameter between said reference and measurement areas comprises:

- calculation, from the measurement of the spatial periodicity and the orientation of the interference fringes, of a difference between the components of the wave vectors of the beams diffracted by the measurement area and by the reference area;
- determination, during said calibration step vi), of a component of a wave vector representing the deflection introduced by said device (BP); and
- subtraction of said component of the wave vector representing the deflection introduced by said device from said difference between the components of the wave vector of the diffracted beams;

which yields as a result a difference between the components of the reciprocal crystal lattice vectors of said reference and measurement areas, indicative of a deformation of the latter at the nanoscale.

**6.** The method as claimed in one of the preceding claims, in which said or each step of measuring the spatial periodicity of interference fringes comprises:

iv-a) acquisition of an image of the interference pattern (FI) at said image plane;
iv-b) conversion of said image into a digital format; and
iv-c) determination of the periodicity of said fringes by an image processing method.

**7.** The method as claimed in one of the preceding claims, in which steps ii) to v) are repeated a second time, using the beams ($F^1_A$, $F^1_B$) diffracted according to diffraction vectors that are not colinear with the diffraction vectors of the first measurement, and preferably also a third time using the beams ($F^1_A$, $F^1_B$) diffracted according to diffraction vectors that are not coplanar with the diffraction vectors of the first and second measurement, in order to determine a two-dimensional or three-dimensional deformation tensor respectively for the measurement area (B) of said specimen.

**8.** The method as claimed in one of the preceding claims, in which the specimen is approximately transparent to the incident radiation ($F^{in}$) and a forward diffraction of said radiation is used for the measurement.

**9.** The method as claimed in one of the preceding claims, in which the radiation used ($F^{in}$) consists of an electron beam.

**10.** A system for measuring nanoscale deformations in a portion of a crystal specimen by a method as claimed in one of the preceding claims, **characterized in that** said system comprises:

- a support (18) for a crystal specimen in the form of a wafer with approximately parallel faces;
- illumination means (11, 12) for illuminating one face of said specimen with a spatially coherent beam of radiation ($F^{in}$) capable of being diffracted by the crystal lattice of the specimen (A, B);

- an optical assembly (13, 14, BP, 15, 16) for superposing a beam of radiation (F\) diffracted by a first area of the specimen with a beam of the same radiation diffracted, to the same order, by a second area ($F^1_A$), coplanar with said first area, so as to cause these two diffracted beams to interfere at a plane called the image plane (PI);
- a means (17) for measuring the spatial periodicity of the fringes of the resulting interference pattern; and
- a data processing means (20) for calculating, from said spatial periodicity, a difference in the lattice parameter between said first and second areas of the specimen, which is indicative of a state of deformation of one of these areas relative to the other at the nanoscale.

**FIG.1**

**FIG.2**

FIG.3

CE

LC

FE

PE
DF

E

LO

D

L1

DL1

BP

PI1

L2

PI2

AO

LP

SD

# FIG.4a

**FIG.4b**

LO

DF1

PPE

PP

DF2

PF-LO

FIG.5

LO

L1

TR

DL1

S

C

B

source

drain

D

A'

H

SP

X

A

50 nm

-3% +3%

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7015469 B

**Littérature non-brevet citée dans la description**

- **B. FORAN et al.** Strain measurement by transmission electron microscopy. *Future Fab International,* 2006, vol. 20, 127
- **M. M. J. TREACY et al.** On elastic relaxation and long wavelength microstructures in spinoidally decomposed InxGa1-xAsyP1-y epitaxial layers. *Philos. Mag. A,* 1985, vol. 51, 389
- Electron Microscopy of Thin Crystals. **P. B. HIRSCH et al.** Electron Microscopy of Thin Crystals. Krieger, 1977
- **T. ISHITANI ; K. UMEMURA ; T. OHNISHI ; T. YAGUCHI ; T. KAMINO.** Improvements in performance of focused ion beam cross-sectioning: aspects of ion-sample interaction. *Journal of Electron Microscopy,* 2004, vol. 53, 443-449
- **M. J. HÿTCH et al.** Quantitative measurement of displacement and strain fields from HREM micrographs. *Ultramicroscopy,* 1998, vol. 74, 131

- **HÜE et al.** Calibration of projector lens distortions. *J. Electron Microscopy,* 2005, vol. 54, 181-190
- **K TSUNO ; T TAOKA.** *Japanese Journal of Applied Physics,* 1983, vol. 22, 1041
- **JOHN M. RODENBURG.** Understanding Transmission Electron Microscope Alignment : A Tutorial. *Microscopy and Analysis,* 2004, vol. 18 (3), 9-11
- **M.A. SCHOFIELD ; M. BELEGGIA ; Y. ZHU ; G. POZZI.** Characterization of JEOL 2100F Lorentz-TEM for low-magnification electron holography and magnetic imaging. *Ultramicroscopy,* 2007
- **E. SNOECK ; P. HARTEL ; H. MUELLER ; M. HAIDER ; P.C. TIEMEIJER.** Using a CEOS-objective lens corrector as a pseudo Lorentz lens in a Tecnai F20 TEM. *Proc. IMC16 Sapporo,* 2006